(19) Europäisches Patentamt European Patent Office Office européen des brevets

(11) **EP 4 657 009 A1**

(12) **EUROPEAN PATENT APPLICATION**

(43) Date of publication:
**03.12.2025 Bulletin 2025/49**

(21) Application number: **24178736.5**

(22) Date of filing: **29.05.2024**

(51) International Patent Classification (IPC):
**G01B 9/02055** *(2022.01)* **G01B 21/04** *(2006.01)*
**G03F 7/00** *(2006.01)*

(52) Cooperative Patent Classification (CPC):
**G01B 9/02072; G01B 21/042; G01B 21/045;
G03F 7/70516**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
- **ASML Netherlands B.V.**
  **5500 AH Veldhoven (NL)**
- **Carl Zeiss SMT GmbH**
  **73447 Oberkochen (DE)**

(72) Inventors:
- **VALENTIN, Christiaan, Louis**
  **5500 AH Veldhoven (NL)**
- **HELLER, Pascal**
  **73447 Oberkochen (DE)**
- **TEL, Wouter**
  **5500 AH Veldhoven (NL)**

- **LILIENFEIN, Nikolai, Maria**
  **73447 Oberkochen (DE)**
- **VAN GHELUWE, Jochen, Renaat**
  **5500 AH Veldhoven (NL)**
- **MRIDHA, Manoj Kumar**
  **5500 AH Veldhoven (NL)**
- **KWEE, Patrick**
  **5500 AH Veldhoven (NL)**

(74) Representative: **ASML Netherlands B.V.**
**Corporate Intellectual Property**
**P.O. Box 324**
**5500 AH Veldhoven (NL)**

Remarks:
A request for correction of the description has been filed pursuant to Rule 139 EPC. A decision on the request will be taken during the proceedings before the Examining Division (Guidelines for Examination in the EPO, A-V, 3.).

(54) **METHOD FOR CALIBRATING AN OPTICAL MEASUREMENT SYSTEM AND SYSTEM ADAPTED TO IMPLEMENT THE METHOD**

(57) The present disclosure provides a method for calibrating an optical measurement system involving radiation interference, the method comprising the steps of: determining an error of the optical measurement system during a first measurement, wherein a target of the optical measurement system is tilted in one or more degrees of freedom; defining parameters of an error model function based on the first measurement; determining an error of the optical measurement system during at least one second measurement, wherein the at least one second measurement comprises fewer data points than the first measurement; and updating a subset of the parameters of the error model function to define an updated error model function based on the at least one second measurement.

Fig. 7

EP 4 657 009 A1

**Description**

<u>FIELD</u>

The present invention relates to a method for calibrating an optical measurement system involving radiation interference. The measurement system may typically include one or more interferometers. The invention also relates to a system adapted to implement the method. The system and method may, for instance, be applied in various steps of an exposure process, for example a lithographic process, or in equipment related to an exposure process, including in or relating to an exposure apparatus, for example a lithographic apparatus. The invention also relates to projection systems for optical lithography systems.

<u>BACKGROUND</u>

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses a reflective surfaces instead of a lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

Lithographic scanners typically include stages and optical elements such as mirrors which need to be positioned very accurately to achieve the desired overlay performance. Displacement interferometers may typically be used to determine positioning requirements on the basis of a repetitive signal.

Displacement measuring interferometers monitor changes in the position of a measurement object relative to a reference object based on an optical interference signal. The interferometer generates the optical interference signal by overlapping and interfering a measurement beam reflected from the measurement object with a reference beam reflected from the reference object.

In many applications, the measurement and reference beams have orthogonal polarizations and different frequencies. The different frequencies can be produced, for example, by laser Zeeman splitting, by acousto-optical modulation, or internal to the laser using birefringent elements or the like. The orthogonal polarizations allow a polarizing beam splitter to direct the measurement and reference beams to the measurement and reference objects, respectively, and combine the reflected measurement and reference beams to form overlapping exit measurement and reference beams. The overlapping exit beams form an output beam that subsequently passes through a polarizer. The polarizer mixes polarizations of the exit measurement and reference beams to form a mixed beam. Components of the exit measurement and reference beams in the mixed beam interfere with one another so that the intensity of the mixed beam varies with the relative phase of the exit measurement and reference beams. A detector measures the time-dependent intensity of the mixed beam and generates an electrical interference signal proportional to that intensity. Because the measurement and reference beams have different frequencies, the electrical interference signal includes a "heterodyne" signal having a beat frequency equal to the difference between the frequencies of the exit measurement and reference beams. If the lengths of the measurement and reference paths are changing relative to one another, e.g., by translating a stage that includes the measurement object, the measured beat frequency includes a Doppler shift equal to $2unp/l$, where $u$ is the relative speed of the measurement and reference objects, $l$ is the wavelength of the measurement and reference beams, $n$ is the refractive index of the medium through which the light beams travel, e.g., air or vacuum, and $p$ is the number of passes to the reference and measurement objects. Changes in the relative position of the measurement object correspond to changes in the phase of the measured interference signal, with a 2pi phase change substantially equal to a distance change $L_{RT}$ of $l/(np)$, where $L_{RT}$ is a round-trip distance change, e.g., the change in distance to and from a stage that includes the measurement object.

Unfortunately, this equality is not always exact. Many interferometers include nonlinearities such as what are known as "cyclic errors." The cyclic errors can be expressed as contributions to the phase and/or the intensity of the measured interference signal and have a sinusoidal dependence on the change in optical path length $pnL_{RT}$. For example, a first order harmonic cyclic error in phase may have a sinusoidal dependence on $(2ppnL_{RT})/l$ and a second order harmonic cyclic error in phase may have a sinusoidal dependence on $2(2ppnL_{RT})/l$. Additional cyclic errors may include higher order harmonic cyclic errors, negative order harmonic cyclic errors, and sub-harmonic cyclic errors.

Cyclic errors can be produced by "beam mixing," in which a portion of an input beam that nominally forms the reference beam propagates along the measurement path and/or a portion of an input beam that nominally forms the measurement beam propagates along the reference path. Such beam mixing can be caused by ellipticity in the polarizations of the input beams and imperfections in the interferometer components, for instance, imperfections in a polarizing beam splitter used to direct orthogonally polarized input beams along respective reference and measurement paths. Because of beam mixing and the resulting cyclic errors, there is not a strictly linear relation between changes in the phase of the measured interference signal and the relative optical path length $pnL$ between the reference and measurement paths. If not compensated, cyclic errors caused by beam mixing can limit the accuracy of distance changes measured by an interferometer. Cyclic errors can also be produced by imperfections in transmissive surfaces that produce undesired multiple reflections within the interferometer and imperfections in components such as (retro)reflectors and/or phase retardation plates that produce undesired ellipticities in beams in the interferometer.

Summarizing the above, interferometers suffer inherently from cyclic errors, also known as periodic non-linearities. These periodic non-linearities are errors of the repetitive signal that depend on the phase of the signal. Methods exist to measure and compensate for such cyclic errors to a certain extent, in particular by modelling each harmonic order with a harmonic function of the measurement signal and determining its amplitude and phase parameters from measurements. Yet, in addition, the cyclic error is also influenced by errors in tilt of the target reflector. In many cases a relatively straightforward compensation is possible by modelling the cyclic error amplitude and phase as linear functions of Rx-Ry, i.e. across the tip-tilt plane of the target. However, in some interferometer types, the cyclic error exhibits higher order (non-linear) influences of rotation of the target and relatively complex error patterns.US 11287242 B2 discloses an interferometer system, including a heterodyne interferometer and a processing system. The processing system is arranged to determine a cyclic error of the heterodyne interferometer based on a reference phase, a measurement phase and an amplitude. Calibration of the interferometer system is carried out via subtraction of tilt-dependent correction values, which are derived by interpolation between periodic non-linearity measurement values at a set of tilt positions. The measurement is repeated, and correction values are updated, after regular time intervals to account for drifts of the cyclic error.

Although the calibration method as disclosed in US 11287242 B2 generally enables to significantly improve on and calibrate for cyclic errors, in interferometers exhibiting complex error patterns, a dense sampling of the tip/tilt plane is required to capture the pattern. As a result, the measurement requires a significant amount of time, typically on the order of a number of hours. Moreover, periodically repeating the method is required to compensate for thermal drift. During these calibration measurements, the respective machine involved in the lithographic process will be out of operation, which in turn directly negatively impacts yield and profit. Herein, please note that the method and the related models as disclosed in US 11287242 B2 already provide a significant improvement over other conventional methods, which require much longer to calibrate interferometer systems.US 6950192 B2 discloses a calibration method based on a main interferometric signal, from which coefficients representative of cyclic error can be determined, and in turn used to estimate a quadrature signal for the main interferometric signal.

Existing linear models cannot correct higher order tilt dependencies of periodic non-linearities. As other existing models for calibrating cyclic error contributions in interferometers, the method of US 6950192 B2 is typically too time consuming to repeat periodically, causing significant machine downtime.

The present disclosure aims to provide an improved calibration method, obviating one or more of the disadvantages relating to the prior art as outlined above.

## SUMMARY

The present disclosure provides a method for calibrating an optical measurement system involving radiation interference, the method comprising the steps of:

determining an error of the optical measurement system during a first measurement, wherein a target of the optical measurement system is tilted in one or more degrees of freedom;

defining parameters of an error model function based on the first measurement;
determining an error of the optical measurement system during at least one second measurement, wherein the at least one second measurement comprises fewer data points than the first measurement; and
updating a subset of the parameters of the error model function to define an updated error model function based on the at least one second measurement.

In an embodiment, the error model function comprises non-linear tilt dependencies.
In an embodiment, the error model function comprises periodic dependencies of a measurement signal as provided by the optical measurement system.
In an embodiment, the method comprises the step of describing said non-linear tilt dependencies as phasor functions,, wherein at least one of the angles (phase) or the absolutes (amplitude) of at least one of the phasor functions comprises non-linear tilt-dependencies.
In an embodiment, each phasor function is comprised of a sum of at least two contributor phasor functions.
In an embodiment, angles of the at least two contributor phasors are parametrized such that their difference is a non-constant function of the tilt.
In an embodiment, the target of the optical measurement system has a range of tilt positions.
In an embodiment, the step of determining an error during a first measurement comprises measuring over N points a first optical characteristic for the target at a first position or first angular orientation,
the method comprising the steps of:

determining, based on the first optical characteristic, a first set of P parameters indicative of observed physical effects including tilt-dependent non-linearities, to provide the error model function,
using said error model function as basis of further correction,
wherein the step of updating a subset of the parameters comprising measuring over M points a further optical characteristic for the target, where M < N,
determining, based on the measurement over M points and the physical model, a correction to the measurement over M points to reduce tilt-dependent non-linearities, and
updating a subset of the first set of P parameters on the basis of the measurement over M points to provide the updated error model function.

In an embodiment, the absolute of at least one of the phasors is an oscillating tilt dependency with varying amplitude.
In an embodiment, the non-constant function of the tilt is an oscillating tilt-dependency with Gaussian envelope.
In an embodiment, the optical measurement system is an interferometer system.
According to another aspect, the disclosure provides an optical measurement system involving radiation interference, the system comprising:
first measurement means for determining an error of the optical measurement system, wherein a target of the optical measurement system is tilted in one or more degrees of freedom and for defining parameters of an error model function based on the first measurement;

second measurement means for determining an error of the optical measurement system during at least one second measurement, wherein the at least one second measurement comprises fewer data points than the first measurement; and
a control system adapted for updating a subset of the parameters of the error model function to define an updated error model function based on an output of the second measurement means.

In an embodiment, the system is adapted to implement the method as outlined above.
According to another aspect, the disclosure provides an exposure apparatus, comprising at least one optical measurement system as outlined above.
According to yet another aspect, the disclosure provides a projection system for an optical lithography system, the projection system comprising at least one optical measurement system as outlined above or configured to carry out the method as outlined above.

BRIEF DESCRIPTION OF THE DRAWINGS

Embodiments of the invention will now be described, by way of example only, with reference to the accompanying schematic drawings, in which:

- Figure 1 shows a schematic representation of a lithographic system comprising a lithographic apparatus and a radiation source;
- Figure 2 shows a schematic representation of a system for (actinic) mask inspection;
- Figure 3 shows a schematic representation of an alternative radiation source;
- Figure 4 shows a schematic representation of an exemplary interferometer system, exemplifying tilt of a target;
- Figure 5 shows a graph exemplifying cyclic error in the output of an interferometer system;
- Figure 6 shows graphs exemplifying the components, such as amplitude and phase, adding to total cyclic error;
- Figure 7 shows a schematic representation of steps in a method of the disclosure;
- Figure 8 shows graphs exemplifying steps in a method according to the present disclosure; and
- Figure 9 shows graphs exemplifying steps in a method according to the present disclosure.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

A "beam splitter" (also spelled beamsplitter) is an optical device that splits a beam of light in two.

A "polarizing beam splitter" typically refers to a beam splitter provided with one or more optical elements to polarize one or more of the incoming or outgoing beams. The optical elements may include a waveplate or retarder. A waveplate is an optical device that alters the polarization state of a light wave travelling through it. Two common types of waveplates are a half-wave plate, which shifts the polarization direction of linearly polarized light, and a quarter-wave plate, which converts linearly polarized light into circularly polarized light and vice versa.

A "retroreflector" (sometimes called a retroflector or cataphote) is a device or optical element that reflects radiation, such as light, back to its source with minimum scattering. In the ideal situation, the incident beam and the outgoing beam are substantially parallel. This works at a wide range of angle of incidence, unlike a planar mirror, which does this only if the mirror is exactly perpendicular to the wave front, having a zero angle of incidence. Corner reflectors or corner cubes, and cat's eye reflectors are the most used kinds.

A "beam shifter" or "translating reflector" is a device or optical element that reflects radiation, such as light, such that a mutual distance between the incident beam and the outgoing beam remains substantially the same. The mutual distance remains the same, even when the position of the incident beam shifts or translates with respect to the beam shifter. Contrary to a retroreflector, the incoming beam and outgoing beam are not necessarily parallel to each other. For instance, when the incident beam is directed under an angle with respect to the beam shifter, the outgoing beam will be directed under the same angle yet in the opposite direction.

"Walk-off" herein refers to misalignment of two or more radiation beams, such as laser light beams. Misalignment herein typically refers to a deviation from a design mode of operation.

"Refractive Index" (Index of Refraction) is a value calculated from the ratio of the speed of light in a vacuum to that in a second medium of greater density. The refractive index variable may be symbolized by the letter n or n' in descriptive text and mathematical equations.

An "interferometer" or a "laser interferometer" can measure distance or displacement by measuring the phase difference between two light beams, one sent to a first reflector or first surface at a fixed reference distance, and one sent to a second reflector or surface at another distance. When the two reflected signals are recombined in the interferometer, the resulting phase is related to the distance of the second surface from the interferometer. If the distance of the second surface changes, so does the phase of the combined signal. The utility of these methods are that the measurement can be made over long distances while maintaining accuracy.

A "homodyne interferometer" measures phase by comparing the intensities of two sinusoidal signals (sine and cosine). A single frequency laser source is used in homodyne systems, having for instance frequency F1. The laser beam from the stationary reference path is returned with frequency F1, but the beam from the (moving) measurement path is returned with a Doppler shifted frequency. These beams are interfered together in the detector to give a beat frequency of zero when the optics are stationary, whilst the beat frequency rises as the optics move in either direction.

A "heterodyne interferometer" uses a dual frequency laser source. The laser source may provide a single laser beam, which can be split in two wherein one of the two beams is given a frequency offset to allow for heterodyne phase detection. The two frequencies may however also be generated by two different, frequency-locked or phase-locked lasers.

In a heterodyne interferometer, the output beam from the dual frequency laser source may comprise two polarizations, one with a first frequency F1, the other with a different, second frequency F2. The beat frequency or frequency difference between them is F2 - F1. A polarizing beam-splitter reflects the light with first frequency F1 into the reference path. Light with the second frequency F2 passes through the splitter into the measurement path where it strikes a moving reflector causing the frequency of the reflected beam to be Doppler shifted by $\delta F$. This reflected beam is then combined with the F1 frequency light at the interferometer, and returned to the laser detector unit with a new beat frequency of F2 - F1 $\pm \delta F$. The beat frequency of a heterodyne laser system varies with the velocity of the moving reflector. When the optics are stationary, the beat frequency is F2 - F1. As the optics move apart, the beat frequency rises by $\delta F$, if they move together it falls.

A "wavelength tracker" is a specific version of an interferometer set up to measure a phase difference between two reflected light beams, one beam reflecting on a first fixed reflector providing a first reference axis and a second beam reflecting on a second fixed reflector providing a second reference axis having a different length than the first axis. As the two reflective surfaces are fixed, the measured phase difference will change only if the wavelength of the light beam changes. Thus, a wavelength tracker allows to monitor deviations of the wavelength from a setpoint.

"Polarization" of light refers to an intensity difference between respective polarization states of a laser beam. P-polarized light (from the German word 'parallel') has its electric field polarized parallel to the plane of incidence. S-polarized light (from the German word 'senkrecht') is perpendicular to the plane of incidence.

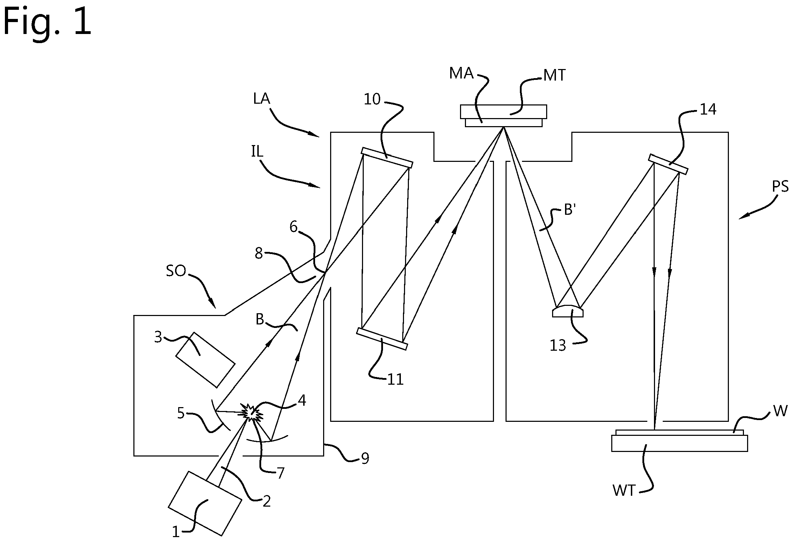

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

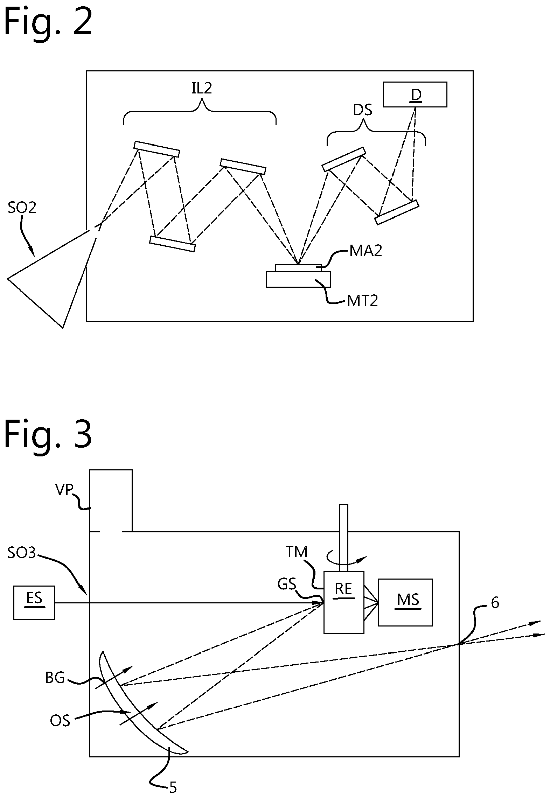

Figure 2 depicts a system for (actinic) mask inspection. A mask inspection system can be used to identify or inspect defects in a mask to be used in a lithographic process by means of an apparatus described in figure 1. The mask inspection system comprises a radiation source SO2 and an illumination system IL2 and a detection system DS. A mask MA2 is placed on a mask stage MT2 and illuminated by the illumination system IL2 reflecting radiation incident from the radiation source SO2. The radiation coming from the illuminated mask is reflected by the detection system DS. In this way an image is formed on a detector D.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

Figure 3 depicts an alternative radiation source SO3. For generating plasma target material TM, like tin or xenon may be provided to a rotating element RE, like for example rotating wheels, cylinder, or a drum or variations thereof. Target material may be provided in liquified form to the one or more rotating elements, e.g. by means of a target material bath. Alternatively, target material may also be provided in solid or frozen form (e.g. Xenon). Gaseous target material may be sprayed onto the rotating element to replace target material transformed to plasma. According to embodiments the rotating element would be cold enough to solidify the target material. An excitation device ES may be used to assist in plasma formation. According to embodiments this excitation device is a laser, like a solid-state or gas laser. Reflective optics OS, like one or more mirrors, can be used to reflect the EUV light generated to the intermediate focus 6. According to embodiments, the reflective optics comprise a collector mirror. Buffer gas flow BG may be provided to mitigate debris present in the radiation source. Also a vacuum pump VP may be provided to remove gas from the radiation source SO3.

As referenced in the introduction, one or more of the moveable elements included in the apparatuses as exemplified above may be provided with position measurement equipment, such as an interferometer system.

For instance, one or more of the mirrors 5, 10, 11, 13, 14 in the lithographic apparatus LA depicted in Fig. 1 may be provided with one or more interferometers. For instance, a respective mirror may be provided with up to six interferometers, to measure the position in up to six degrees of freedom (DoF). Said degrees of freedom include translations x, y, z, and rotations Rx, Ry, Rz. Typically, position measurements and movements of respective elements may be measured and noted in a positioning system linked to the respective element. Likewise, one or more of the substrate stage(s) WT and the mask stage MT may be provided with one or more interferometer systems.

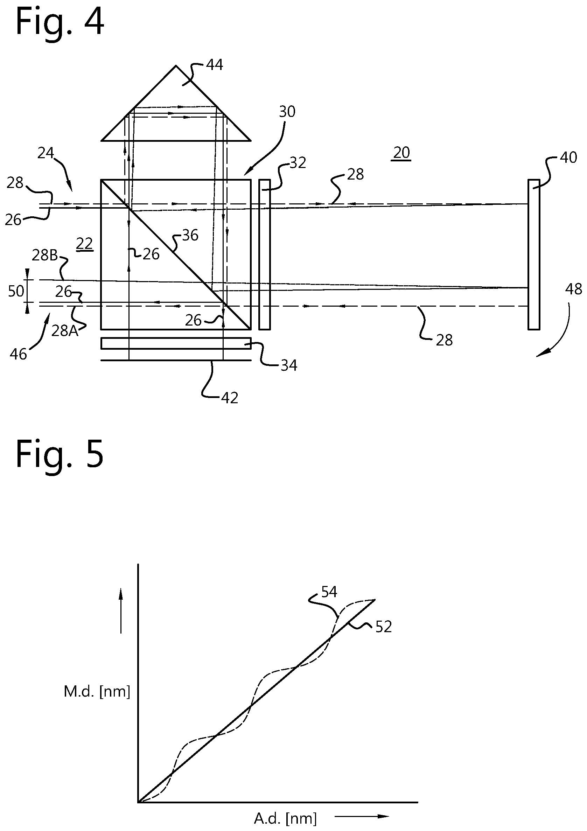

Generally referring to Figure 4, an interferometer 20 may include an input terminal 22 for receiving an input beam 24. The input beam may typically include a reference beam 26 and a measurement beam 28. The respective beams 26 and 28 may each have at least one feature distinguishing one with respect to the other, such as, but not limited to, frequency, wavelength, phase, or polarization.

Please note that the design as depicted in Fig. 4 is exemplary only. The interferometer system 20 in Fig. 4 is a so-called two-pass design. However, the present disclosure is equally applicable to other interferometer systems, such as but not limited to a 4-pass design or a 1-pass design.

The interferometer 20 may include a beam splitter 30 for receiving the input beam 24. The beam splitter 30 may be provided with a first wave plate 32. The beam splitter 30 may be provided with a second wave plate 34. The first wave plate and the second wave plate may be selected from, for instance, a quarter wave plate, and a half wave plate. The beam splitter 30 may have a reflection surface 36. The reflection surface 36 herein may typically be reflective for radiation having certain characteristics, while being transmissive for radiation having other characteristics. For instance, the reflection surface 36 may be reflective for radiation having certain polarization directions, while being transmissive for radiation having other polarization directions.

A first reflector 40 may be connected to a target of choice, such as a reference cavity or a movable object. The interferometer typically includes a second reflector 42. The interferometer may include a third reflector 44.

As exemplified in Figure 4, typically the first reflector may be a flat mirror. The first reflector 40 however may also be any other reflector, such as but not limited to a retroreflector like a corner cube.

The beam splitter is typically a polarizing beam splitter. A polarization beam splitter produces two polarized output beams. One beam is reflected at an angle, and the other beam is let through. The reflected beam is typically called the S-polarization beam, while the beam that is let through is the P-polarization. The beam splitter may comprise two right-angle triangular prisms stacked against each other with a beam-splitting coating dividing them in between. This will make for a reflective surface that will transmit or reflect part of the original unpolarized light beam when set properly. There are different types of reflective coatings used in polarized beam splitters. The type of beam splitter coating dictates how the polarizing beam splitter works. The coating will dictate how much of the original unpolarized light is reflected and how much is let through. Polarized beam splitter cubes may feature a dielectric coating that can be intended for different uses. How much of the original light beam is transmitted or reflected in the s and p polarization may be controlled through this coating.

Due to the combination of the polarizing beam splitter (PBS) 30 and the first and second wave plates 32, 34, a beam re-entering the PBS will follow a different path after the internal splitting surface 36 of the PBS. In use, the beam splitter 30 directs the reference beam 26 towards the second reflector 42. Herein, the reference beam 26 is directed through the second quarter wave plate 34. As a result, the polarization of the reference beam changes. The reference beam 26 is reflected on the second reflector 42 and returned to the beam splitter 30. Due to the changed polarization, the reflection surface 36 will be transmissive for the reflected reference beam and therefore continue towards the third reflector 44. The third reflector may be a retroreflector. On the other hand, the beam splitter 30 directs the measurement beam 28 towards the first reflector 40. Herein, the measurement beam 28 passes through the first quarter wave plate 32. As a result, the polarization of the measurement beam changes. The measurement beam 28 is reflected on the first reflector 40 and returned to the beam splitter 30. Due to the changed polarization, the reflection surface 36 will be reflective for the reflected measurement beam. As a result, the measurement beam is also directed towards the third reflector 44.

In the designs exemplified in Figure 4 both the reference beam 26 and the measurement beam 28 are directed towards the third reflector, are reflected towards the beam splitter 30, and are subsequently once again directed towards their respective targets. Thus, the measurement beam 28 is directed to the first reflector 40 twice, and the reference beam 26 is directed to the second reflector 42 twice. Then, both beams exit the interferometer 20 indicated by exit beam 46. The exit beam is typically directed towards equipment for further processing, typically including detectors, phase measurement etc. As both the measurement and the reference beam may pass the interferometer twice, the interferometer 20 may be referred to as a two-pass interferometer.

In the setup of Figure 4, the first reflector 40 is a flat mirror. In the ideal situation, the measurement beam 28 and the reference beam 26 exiting the beam splitter 30 towards a detector (not shown) coincide. In the exit beam 46, the reference beam 26 and the measurement beam 28A travel along the same axis and in the same direction. A detector subsequently can process the two beams and provide measurement data.

A problem arises when the first reflector 40 rotates. For instance, if the first reflector rotates around an axis perpendicular to the direction of travel of the measurement beam 28, as exemplified by arrow 48, exiting measurement beam 28B and the reference beam 26 travel in slightly different, non-parallel directions. This results in a mutual distance 50 between the reference beam 26 and the measurement beam 28B. Said distance 50 may be referred to as walk-off. Walk-off herein is a deviation from the design value. However, as mentioned before, in addition the tilt in one or both of the Rx and Ry direction of the reflector may also influence the cyclic error CE, and introduce complex non-linearities.

Ideally, measurement systems have a linear relationship between the true displacement of a body and the acquired measurement. In reality, this is not the case. Displacement interferometers have periodic non-linearities. An example of this is shown in the left graph of Figure 5. Herein, the vertical axis represents the measured distance M.d. [nm], as a function of the actual distance A.d. [nm] on the horizontal axis. First line 52 represents the desired signal, which typically would be a straight line. Second line 54, which is oscillating, exemplifies the actual signal, i.e. the behavior that may be observed in the output of an interferometer.

The periodicity of the non-linearities as exemplified by second line 42 may depend on the laser wavelength. Root causes of the error may be one or more of errors in the polarization of the laser beam, polarization leakage inside the interferometer system, ghost reflections, influence of aberrations in coatings, beam splitters and quarter wave plates, optical alignment errors, etc.

The non-linear cyclic errors can be decomposed into several harmonic contributions (such as but not limited to the 1st harmonic, 2nd harmonic, etc.). Herein, each harmonic typically has its own amplitude ($a_{n_k}$) and phase ($\varphi_{n_k}$), i.e.:

$$(z) = \sum_k \hat{a}_{n_k}(R_x, R_y) \sin\left(\frac{2\pi}{\lambda/(2N \cdot n_k)} z\right) v \qquad [1]$$

wherein N is the number of passes of a laser beam to the target of the respective interferometer; $n_k$ is the denominator of the harmonic order; and $\hat{a}_{n_k}(R_x, R_y)$ are complex phasors. N is an integer, in practice typically either 1, 2 or 4. The phasors are functions of the target-to-interferometer tilt $R_x$, $R_y$. The latter indicate tilt of the target with respect to the interferometer system around the x-axis and the y-axis of the target coordinate system respectively.

A phasor, or phase vector, is a complex number representing a sinusoidal function. The amplitude (A) and initial phase (θ) of the function are time-invariant and the angular frequency (ω) is fixed. It is related to a more general concept called analytic representation, which decomposes a sinusoid into the product of a complex constant and a factor depending on time and frequency. The complex constant, which depends on amplitude and phase, is known as the phasor, or complex amplitude.

The phasors can be expressed in terms of the amplitude $a_{nk}$ and the phase $\varphi_{nk}$ :

$$\hat{a}_{n_k}(R_x, R_y) = a_{n_k}(R_x, R_y) \cdot \exp\left(-i\phi_{n_k}(R_x, R_y)\right) \qquad [2]$$

Conventionally, there are two main strategies to minimize the impact of the periodic non-linearities. These are:

1. Optimize the design of the hardware of the interferometer system. Examples include, for instance, using the proper polarization state of the incoming light into the interferometer, optimize alignment of optical surfaces, using a double polarizing beam splitter, application of optimized anti-reflective coatings, using quarter waveplates with optical flatness within strict tolerances, etc.; and
2. Correction of the periodic non-linearities using software. Herein, non-linearities are typically corrected in post-processing of the output signal of the interferometer.

Both conventional methods as described above may provide adequate results for relatively simple errors, such as error functions wherein lower order parameters are the dominant contributing factor. These may be corrected using a relatively simple model, which can be expressed in software and implemented in processing of the output signal of the interferometer.

The conventional methods are, however, less suitable and not as capable for correcting error functions having more complex behavior. Complex behavior may refer to error functions wherein, for instance, higher order parameters are the dominant contributing factor and/or significant and potentially localized non-linearities are included.

The specific non-linearities are becoming more and more important as the overlay performance of lithographic machines is approaching substantially 1 nm. As examples, current state of the art lithographic machines using EUV light for irradiating a substrate already have overlay performance in the 1 to 2 nm range. At these ranges of overlay performance, interferometer systems are used having very strict performance, for instance having a periodic non-linearity of at most 100 picometers. Such periodic non-linearity may be corrected using a software calibration method, which is intended to reduce the remaining error to below 10 picometers. However, at these levels of accuracy, the periodic non-linearities are typically tilt dependent. The latter implies that, as the target mirror tilts with respect to the interferometer, the amplitude and phase of the periodic non-linearity harmonics would change.

Experts expected that the tilt dependency of the amplitude and phase of the cyclic error in interferometer systems would be substantially linear over the x-y plane of the respective target. However, tests of the interferometer systems as used in a state of the art lithographic apparatus have indicated that in practice, the behavior of the interferometers is different than was initially assumed. The cyclic errors as measured in practice include significant non-linearities. For instance, a tilt-dependent variation exhibiting a pattern including a local oscillation was observed. Further investigation revealed that almost all interferometers have these errors, albeit each at a (slightly) different location within their operational tilt range. The existing software calibration methods will not suffice for two main reasons:

1. The models as conventionally used in the software typically assume a linear tilt dependency of the amplitude and phase of periodic non-linearities. The models therefore are unable to capture or compensate for the non-linearities. As outlined above, the remaining periodic non-linearity after calibration using software will therefore be unable to meet the specified accuracy for state of the art applications. Said accuracy may be on the order of 10 picometer, for a present day lithographic apparatus using EUV radiation, or related equipment as used for exposure processes or metrology.
2. If the model as included in the software would be expanded with higher order parameters, to enable the model to fit the observed tilt-dependent and non-linear oscillation patterns, the model and the software would typically need a relatively large measurement layout. Measurement layout herein refers to, for instance, data and processing power. This would significantly increase the time required for calibration. In practice, the time increase is of a magnitude rendering it impossible, or at least economically unviable, to perform a recalibration of the interferometer systems on a daily basis. As mentioned above, said time required would be on the order of several hours, meaning machine downtime of a significant part of a day. Daily re-calibration may be required for an EUV based lithographic apparatus, to compensate for thermal drift and to maintain performance in the aimed for range of 1 to 2 nm.

In addition to the above, it is typically difficult to replace or update interferometer systems in an existing lithographic apparatus. This means that another type of correction is needed to ensure the performance of these systems.

The software based method outlined above may calibrate an interferometer via subtraction of tilt-dependent correction values, which can be derived by interpolation between periodic non-linearity measurement values at a set of tilt positions. The measurement is repeated, and correction values are updated, after regular time intervals to account for drifts of the cyclic error. However, as mentioned before, in practice this method takes several hours and updating on a regular, for instance daily, basis is not viable.

According to the present disclosure, correction values may be derived from a parametric model. This model comprises two superimposed complex-valued functions, which can recreate the tilt-dependent oscillation patterns of the periodic non-linearity. Measurement data is used to determine the model parameters. In the presence of tilt-dependent oscillation patterns, the model significantly reduces the required amount of data with respect to the conventional approach of linear interpolation.

Moreover, in practice, only a small subset of the model parameters are subject to physical drift mechanisms and need to be recalibrated regularly. A small subset herein may refer to one or two out of a multitude of parameters (for instance, but not limited to, in the range of 10 to 15). The recalibration measurements can be performed using significantly less data than the initial calibration measurement, thus minimizing the required measurement time and optimizing system availability. Said minimized measurement time may, in a practical embodiment, be on the order of minutes. For instance, updating the model based on the limited data set and focusing on the subset of parameters may take on the order of 1 to 5 minutes, compared with several hours to update the measurement in a conventional manner. The feasibility of this approach has been demonstrated on experimental data. Details of the system and method will be described herein below.

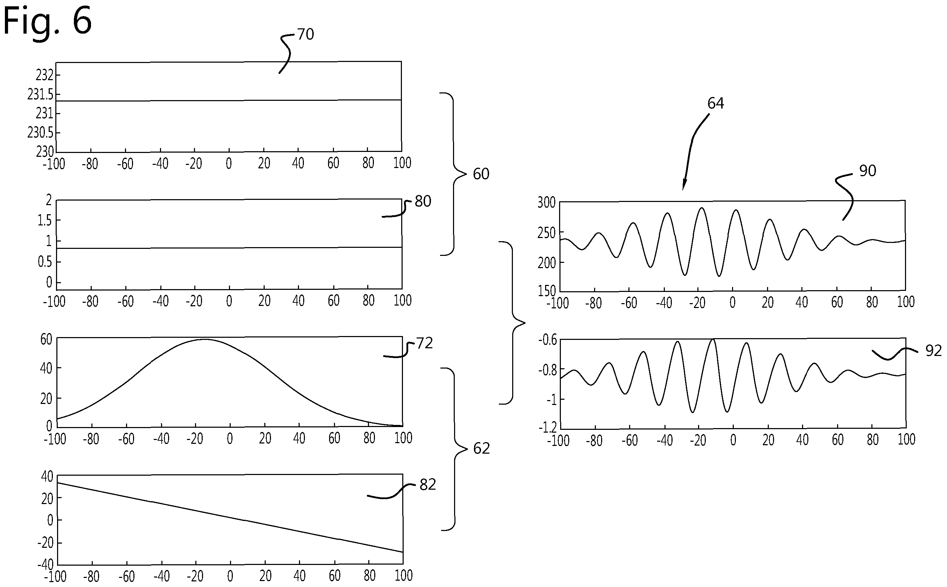

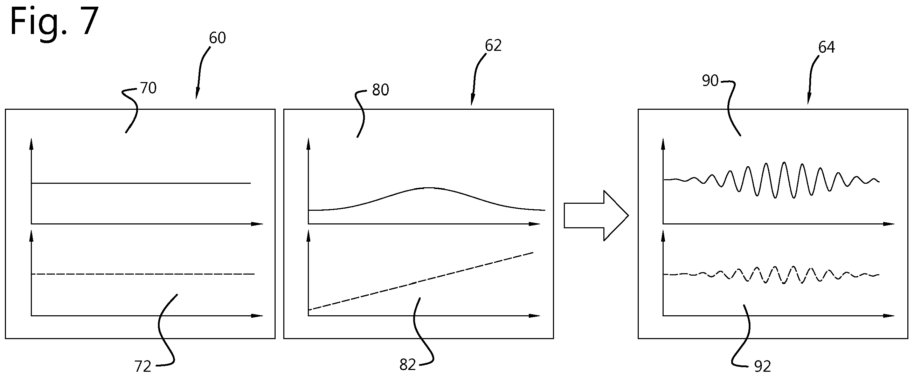

Generally referring to Figures 6 and 7, according to a method of the disclosure, correction values can be derived from evaluating model functions of harmonic phasors (phasor functions). At least a first phasor function 60 and a second phasor function 62 may be used as input. Said input phasor functions are used to derive a model function 64. Each individual phasor function 60, 62 and model function 64 can be expressed in terms of, for instance, two real-valued functions of the tilt. For instance, each phasor function can be expressed in terms of the absolute (amplitude) 70, 80, 90 and the angle (phase) 72, 82, 92 of the respective phasor function.

In a method of the disclosure, in a first step, a first measurement of the cyclic error is performed. The first measurement provides relatively detailed results, allowing to plot cyclic error components for each harmonic. The first measurement may be regarded as an initial measurement. The first measurement may include changing the tilt or rotation of the target over a range of tilts, to measure the influence of the tilt on the output of the measurement system, and thereby measure the resulting (cyclic) error. Changing the tilt of the target may be continuous, over a certain range. Alternatively, changing the tilt of the target may be done in steps over a certain range. Step changes of the tilt may allow static tilt measurements in sequence. The range of tilts may be similar to a typical range of motion (for tilt) of the respective target.

In a next step, the plots for one or more harmonics of the cyclic error are scanned along one or more components of the contributing parameters. For instance, in this second step, plots of interest may be scanned along one or both of the Rx and Ry components. Rx and Ry herein refer to tilt of the respective target along the x-axis and the y-axis respectively of the respective target. This step may focus, for instance, on parameters which have a significant impact when compared to other parameters. In addition, this step may focus on harmonics of the cyclic error which include non-linear components exceeding a certain threshold. Said threshold may for instance be determined by the limit of the cyclic error which can be corrected by a conventional software correction method, as described above.

Figures 6 and 7 indicate plots along a single line relating to Rx. However, each step is equally applicable for other lines and for other parameters, including Ry. For simplicity, the description below will exemplify how to determine an error model function for tilt in the Rx direction. The plots in Figures 6 and 7 relate to the first harmonic component of the cyclic error. However, each step is equally suitable to handle other order harmonic components of the cyclic error. All steps can be applied similarly for other parameters, such as tilt of the target in Ry and Rz direction. Typically however, Rz components of the tilt may have a minor influence.

Each phasor function, as exemplified in Figures 6 and 7, provides an expression of the cyclic error of a respective measurement system. According to the present disclosure, each harmonic phasor function is comprised of a sum of at least two contributor phasor functions 60, 62. For instance, the higher order non-linear phenomena may be interpreted as a combination of at least two cyclic error components, for instance: a leakage error and a ghost ray error. In Figure 6, the first function 60 exemplifies the error component due to leakage and the second function 62 exemplifies the error component due to ghost rays. Herein, ghost rays are unwanted reflections or transmissions within an interferometer. The combined function, also referred to as the model function 64, provides a modeled version of the total cyclic error.

The model function 64 for modeling total cyclic error for rotation or tilt Rx of the target around the x-axis is comprised of, for instance, at least the following four functions:

A first component function 70, which expresses the amplitude component of the cyclic error due to leakage:

$$f_{constant}(Rx) = c_{amp}. \hspace{2cm} [3]$$

A second component function 72, which expresses the phase component of the cyclic error due to leakage:

$$\theta_{constant}(Rx) = c_{phase}. \hspace{2cm} [4]$$

A third component function 80, which expresses the amplitude component of the cyclic error due to ghost rays:

$$f_{gaussian}(Rx) = \frac{a_{gauss}}{\sqrt{2\pi\sigma_{gauss}^2}}\, e^{\frac{-(Rx-d_{gauss})^2}{2\sigma^2}}. \hspace{1.5cm} [5]$$

A fourth component function 82, which expresses the phase component of the cyclic error due to ghost rays:

$$\theta_{linear}(Rx) = a * Rx + b. \hspace{2cm} [6]$$

The four functions 70, 72, 80, 82 provide a number of parameters, for instance seven parameters: $c_{amp}$, $c_{phase}$, , $a_{gauss}$, $d_{gauss}$, $\sigma_{gauss}$, $a_{lin}$, $b_{lin}$. Herein, $c_{amp}$ may be a constant. Herein, $c_{phase}$ may be a constant.

In a next step, a function may be defined that represents the remaining error in the interferometer signal. The remaining error can be defined based on the model and the measured datapoints: $f(p) = e_{remaining}$. Herein, p is the parameter set:

$$p = \begin{bmatrix} c_{amp} & c_{phase} & a_{gauss} & d_{gauss} & \sigma_{gauss} & a_{lin} & b_{lin} \end{bmatrix} . \hspace{0.5cm} [7]$$

A non-linear optimization algorithm can be used to minimize the remaining error:

$$\min_p f(p). \hspace{2cm} [8]$$

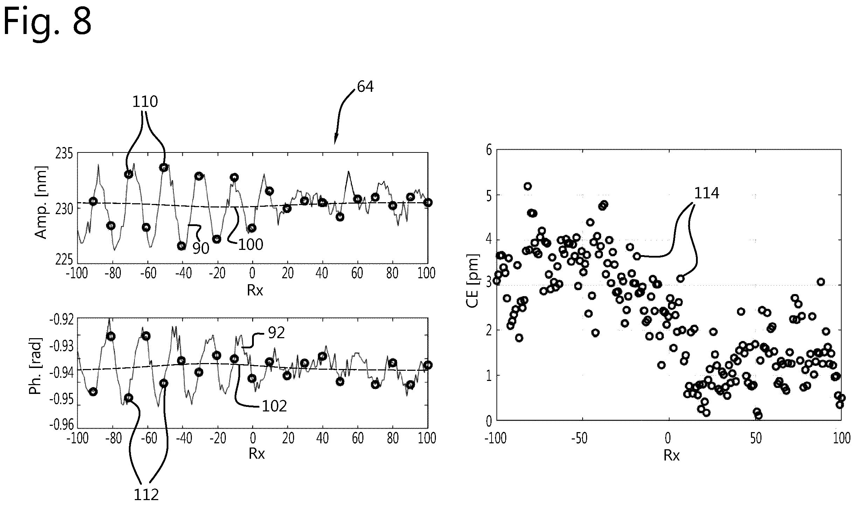

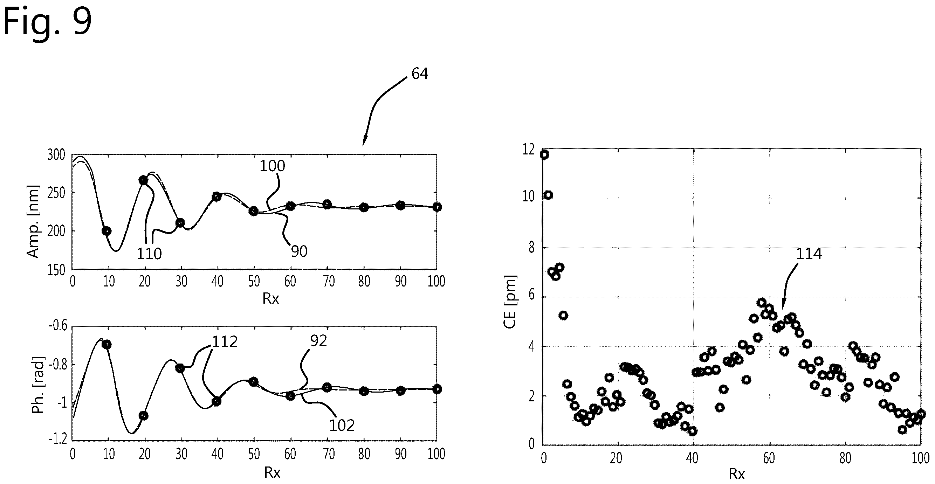

Generally referring to Figures 8 and 9, subsequently, a model function 100, 102 is fitted to the data of a first or initial calibration measurement. The latter may include a tilt-resolved first calibration measurement. The first measurement is represented by first component 90, for instance the amplitude component, and second component 92, for instance the phase component, of the total error function 64. This basically means that the values of the error function are minimized, i.e. the error model function is fit to the results of the first or initial measurement.

Herein, first, a set of model parameters p may be estimated. Then, the minimum of the remaining error function is determined. Said minimum can be determined using, for instance, the 'fminunc' function in MatLab (a software program by MathWorks®).

The optimization process may provide a maximum remaining error 110 (Fig. 8), 112 (Fig. 9) on the order of 10 pm or less. Herein, the x-axis represents Rx in [μrad], and the y-axis represents the maximum remaining error per sample point in [pm].

As an example, a dataset from the test rig executing the first measurement may comprise a first number of sample points M in Rx direction. Herein, M may be on the order of 200. For a measurement layout this dense there would be little use for modelling, in view of the time required. To reduce the time for re-calibration, the method of the disclosure aims to use at least one second measurement comprising a second number of sample points N, wherein N is smaller than M. The second measurement will allow significantly faster processing due to the limited amount of samples, while still being able to provide the required accuracy.

The method of the disclosure may use the following steps. First, obtain a subset of sample points N from the first measurement comprising a first set of M sample points. Second, perform optimization. Third, evaluate the error model for all Rx (and/or Ry) values in the first measurement set. And finally, calculate the remaining error for all Rx and/or Ry values.

The method of the disclosure may be summarized as: Performing a first, detailed measurement using a relatively large first number M of sample points; Preparing a model function of the cyclic error using a combination of at least two component functions; fitting the model function to provide a fitted model function; expressing the fitted model function using a number of parameters; determining a limited number of dominant parameters; and re-calibrating the fitted model function during at least one second measurement, using a limited number of N < M sample points and focusing on the dominant parameters.

Generally referring to Figure 9, the limited number of sample points N of the at least one second measurement for re-calibration may be on the order of 5 to 10% of the M number of sample points of the detailed first measurement. In a practical embodiment, M may be on the order of 200, while N may be on the order of 10 to 20. In a practical embodiment, the maximum remaining error per sample point may be about 16 pm or less for N is 10, down to a maximum on the order of 10 pm for N is 20. The limited number of dominant parameters contributing to changes, or drift, of the cyclic error, may be 1 or 2. For instance, the dominant parameters may include one or both of Rx and Ry, i.e. tilt of the target around the respective x-axis or y-axis.

Application of the calibration of the method steps may involve carrying out a system measurement and subtracting the values of the updated error model function from the values of that measurement.

The above is an outline of a basic version of a re-calibration method according to the disclosure. The basic version may provide suitable results, i.e. within set accuracy levels, for at least a few if not most of the harmonics of the cyclic error. For a subset, for instance for one or two harmonics, a more elaborate model function may be required to achieve remaining cyclic error not exceeding a set threshold. More elaborate herein may refer to one or more of, for instance, using more sample points N for re-calibration (more than 10% of M), using more than two phasors to arrive at the model function 64, using a relatively accurate fitting method, etc.

The model in Rx direction, as described above, can be extended to a two dimensional model, i.e. Rx and Ry. The gaussian distribution function that is used for the amplitude of the ghost ray component can be extended to a two-dimensional distribution:

$$f(x,y) = \frac{a_{gauss}}{2\pi\sigma_X\sigma_Y\sqrt{1-\rho^2}}e^{-\frac{1}{2(1-\rho^2)}\left(\left(\frac{x-\mu_X}{\sigma_X}\right)^2+\left(\frac{Y-\mu_Y}{\sigma_Y}\right)^2-2\rho\left(\frac{x-\mu_X}{\sigma_X}\right)\left(\frac{y-\mu_Y}{\sigma_Y}\right)\right)} \qquad [9]$$

Herein: $\rho$ is the correlation between Rx and Ry; $\sigma_X$ is the standard deviation in Rx direction; $\sigma_Y$ is the standard deviation in Ry direction; $\mu_X$ is the offset in Rx direction; and $\mu_Y$ is the offset in Ry direction.

The linear function that is used for the phase of the ghost ray component may be kept as is, because there seems to be no phase change due to Rx rotations. The constant amplitude and phase from the leakage component can stay as is.

The correlation between Rx and Ry direction, $\rho$, causes the distribution to warp towards the line Rx = Ry. There is no physical phenomenon that would suggest a correlation larger then zero. This is also not seen in data gathered from tests and simulations. Therefore, in formula 9, it can be assumes that $\rho = 0$.

The standard deviations $\sigma_X$ and $\sigma_Y$ determine the width of the normal distribution in Rx and Ry direction. The ghost ray error is typically caused by a physical phenomenon of a certain surface in the respective interferometer aligned with the target mirror. This effect is typically the same in Rx and Ry direction. Therefore, it can be assumed that $\sigma_X = \sigma_Y$. If we can assume $\rho = 0$ and $\sigma_X = \sigma_Y$ the model is determined by the following four equations:

$$f_{gaussian}(Rx, Ry) = \frac{a_{gauss}}{2\pi\sigma_{XY}}e^{-\frac{1}{2}\left(\left(\frac{Rx-\mu_X}{\sigma_{XY}}\right)^2+\left(\frac{Ry-\mu_Y}{\sigma_{XY}}\right)^2\right)} \qquad [10]$$

$$f_{constant}(Rx) = c_{amp} \qquad [11]$$

$$\theta_{constant}(Rx) = c_{phase} \qquad [12]$$

$$\theta_{linear}(Rx) = a_{lin} * Rx + b_{lin} \qquad [13]$$

The above indicates that for the two dimensional case, there are about eight parameters, which is only one more then in the one-dimensional case. Thus, speed of re-calibrating the two-dimensional version of the model function may be comparable to the speed of re-calibrating for a single tilt direction only.

The two-dimensional model described above is based on the assumption that the waves observed in Rx direction depend only on Rx. However, typically, the test data indicates that there is some influence in the waves of the non-linearities for the harmonics of the error function in Ry direction.

Herein below, some additional detail and background is provided relating to the method of the disclosure, and describing higher order non-linear phenomena.

The amplitude and phase plots below contain all the necessary information to deduce the cyclic error, which is a simple sine wave: $f_{CE}(a, \delta) = a \cdot \sin(\theta - \delta)$. For a certain Rx and Ry we can construct the modelled and measured cyclic error using the four parameters: $a_{meas}$, $\delta_{meas}$, $a_{model}$, $\delta_{model}$.

These four parameters ($a_{meas}$, $\delta_{meas}$, $a_{model}$, $\delta_{model}$) can be used to construct the modelled cyclic error $e_{model}$ and measured cyclic error $e_{meas}$, enabling to calculate a remaining error $e_{rem}$:

$$e_{model} = a_{model} \cdot \sin(\theta - \delta_{model}) \qquad [14]$$

$$e_{meas} = a_{meas} \cdot \sin(\theta - \delta_{meas}) \qquad [15]$$

$$\theta \in [0, 2\pi] \qquad [16]$$

$$e_{rem} = max|e_{meas} - e_{model}| \qquad [17]$$

The cyclic error typically comprises several harmonics. Each harmonic can be described as a simple sine wave:

$$f(\theta) = a \cdot \sin(\theta - \delta) \qquad [18]$$

wherein $\theta$ is a function of the sensor to target distance.

Because the cyclic error in interferometers is typically tilt dependent, the parameters $\delta$ and $a$ that define the cyclic error are not constant but vary with tilt of the target. As each harmonic can be described by a simple sine wave, if we have a plot of the amplitude and phase as a function of the tilt, we have all the information to reconstruct the cyclic error.

Each harmonic of the cyclic error can be comprised of several components. For instance, the first harmonic in the error measurements can be described as a sum of a leakage component and a ghost ray component. Each component has its amplitude and phase characteristics. It may be possible to describe the leakage component of the cyclic error as a constant amplitude and a constant phase. The phase of the ghost ray component may be a linearly increasing phase component. The amplitude of the ghost ray component may substantially follow a normal distribution.

According to the disclosure, the angles of the two contributor phasors are parametrized such that their difference is a non-constant function of the tilt (in particular an inclined plane). This property allows for modelling the observed tilt-dependent oscillation pattern of the periodic nonlinearity.

Furthermore, the absolute of at least one of the phasors is a non-constant function of the tilt (in particular a 2D-Gaussian function). This allows for modelling the localized nature of the observed tilt-dependent oscillation features.

The model parameters are optimized to fit the measured error of a tilt-resolved initial calibration measurement. The initial calibration requires a number of individual measurements at separate tilt positions. For instance, the initial calibration uses N measurement points.

The model can be updated by re-fitting a subset of the model parameters (i.e., those that are known by prior knowledge of physical mechanisms and/or previous experience to be subject to drift) to error measurements at a reduced number M < N of tilt positions. Herein, the other parameters may be kept at the original values derived during the initial calibration.

The tilt positions for the recalibration measurements can be optimized to maximize the sensitivity of the targeted model parameters to the measurement. These recalibration measurements and the intervals between them can be optimized to maximize throughput, while minimizing residual errors. For instance, these tilt positions can be automatically determined based on the maxima of the derivatives of the model function with respect to the model parameters chosen for recalibration.

It is proposed to use a physical model to improve the timing of a (re)calibration to reduce tilt-dependent cyclic errors, where the phase of the cyclic error is corrected. This calibration reduces the amount of required data points with respect to conventional linear interpolation approaches, and therefore the recalibration time is significantly reduced.

The model comprises two superimposed complex-valued functions, which can recreate the tilt-dependent oscillation patterns of the periodic nonlinearity.

An initial calibration is carried out to determine the physical model. This initial map fits a model of observed physical effects. Only a small subset of the model parameters are subject to physical drift mechanisms, therefore fewer parameters need to be recalibrated regularly. As fewer points are subsequently required for recalibration, time is saved.

A model function is constructed from the sum of at least two contributor phasor functions, wherein each contributor phasor function comprises an amplitude and a phase. The angles of each contributor phasor function are parameterized such that their difference is a non-constant function of the tilt. The absolute of at least one of the contributor phasors is also a non-constant function of the tilt.

The method and system of the disclosure obviate extensive tilt grid calibrations. Initial calibration can be performed with a much smaller measurement layout than would be necessary when using a conventional linear interpolation method. The recalibration method according to the disclosure can be performed with an even smaller number of measurements.

The method of the disclosure allows to cope with existing interferometer hardware flaws while still securing state of the art performance and accuracy. The benefits of the present disclosure over existing technology include, for instance: reducing the On-Product-Overlay (OPO) penalty by the periodic non-linearities of the Mirror interferometers from 100 pm to about 26 pm (see snapshot below); improvement of scanner availability by obviating a full-blown calibration, and instead enabling an update of the original calibration using a parameterized model and a limited number of measurements. Assuming the need of a daily calibration, this would, in a practical example of a real-life situation directed at interferometer use in a lithographic apparatus, reduce the recalibration time from about 20 hours to 1 hour. Re-calibration based on a subset of parameters and a limited number of data points (with respect to the initial calibration) can be done in a matter of minutes, enabling regular re-calibration with minimum down-time.

It is conceivable that the proposed calibration method as exemplified above can correct higher order errors that are not cyclic errors.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. Other aspects of the invention are set out as in the following numbered clauses.

1. A method for calibrating an optical measurement system involving radiation interference, the method comprising the steps of:

   determining an error of the optical measurement system during a first measurement, wherein a target of the optical measurement system is tilted in one or more degrees of freedom;
   defining parameters of an error model function based on the first measurement; determining an error of the optical measurement system during at least one second measurement, wherein the at least one second measurement comprises fewer data points than the first measurement; and
   updating a subset of the parameters of the error model function to define an updated error model function based on the at least one second measurement.

2. The method of clause 1, wherein the error model function comprises non-linear tilt dependencies.

3. The method of clause 2, wherein the error model function comprises periodic dependencies of a measurement signal as provided by the optical measurement system.

4. The method of clause 2 or 3, the method comprising the step of describing said non-linear tilt dependencies as phasor functions, wherein at least one of the angles (phase) or the absolutes (amplitude) of at least one of the phasor functions comprises non-linear tilt-dependencies.

5. The method of one of clause 2 to 4, wherein each phasor function is comprised of a sum of at least two contributor phasor functions.

6. The method of clause 5, wherein angles of the at least two contributor phasors are parametrized such that their difference is a non-constant function of the tilt.

7. The method of one of the previous clauses, wherein the target of the optical measurement system has a range of tilt positions.

8. The method of one of the previous clauses, wherein

   the step of determining an error during a first measurement comprises measuring over N points a first optical characteristic for the target at a first position or first angular orientation,
   and wherein the method comprises the steps of:

determining, based on the first optical characteristic, a first set of P parameters indicative of observed physical effects including tilt-dependent non-linearities, to provide the error model function, using said error model function as basis of further correction,

wherein the step of updating a subset of the parameters comprising measuring over M points a further optical characteristic for the target, where M < N,

determining, based on the measurement over M points and the physical model, a correction to the measurement over M points to reduce tilt-dependent non-linearities, and
updating a subset of the first set of P parameters on the basis of the measurement over M points to provide the updated error model function.

9. The method of clause 3, 4 or 8, wherein the absolute of at least one of the phasors is an oscillating tilt dependency with varying amplitude.
10. The method of clause 9, wherein the non-constant function of the tilt is an oscillating tilt-dependency with Gaussian envelope.
11. The method of one of the previous clauses, wherein the optical measurement system is an interferometer system.
12. Optical measurement system involving radiation interference, the system comprising:
first measurement means for determining an error of the optical measurement system, wherein a target of the optical measurement system is tilted in one or more degrees of freedom and for defining parameters of an error model function based on the first measurement;

second measurement means for determining an error of the optical measurement system during at least one second measurement, wherein the at least one second measurement comprises fewer data points than the first measurement; and
a control system adapted for updating a subset of the parameters of the error model function to define an updated error model function based on an output of the second measurement means.

13. The system of clause 12, adapted to implement the method according to one of clauses 1 to 11.
14. An exposure apparatus, comprising at least one optical measurement system according to clause 12.
15. A projection system for an optical lithography system, the projection system comprising at least one optical measurement system according to clause 12 or configured to carry out the method of any of clauses 1 to 11.

## Claims

1.  A method for calibrating an optical measurement system involving radiation interference, the method comprising the steps of:

    determining an error of the optical measurement system during a first measurement, wherein a target of the optical measurement system is tilted in one or more degrees of freedom;
    defining parameters of an error model function based on the first measurement; determining an error of the optical measurement system during at least one second measurement, wherein the at least one second measurement comprises fewer data points than the first measurement; and
    updating a subset of the parameters of the error model function to define an updated error model function based on the at least one second measurement.

2.  The method of claim 1, wherein the error model function comprises non-linear tilt dependencies.

3.  The method of claim 2, wherein the error model function comprises periodic dependencies of a measurement signal as provided by the optical measurement system.

4.  The method of claim 2 or 3, the method comprising the step of describing said non-linear tilt dependencies as phasor functions, wherein at least one of the angles (phase) or the absolutes (amplitude) of at least one of the phasor functions comprises non-linear tilt-dependencies.

5.  The method of one of claim 2 to 4, wherein each phasor function is comprised of a sum of at least two contributor phasor functions.

**6.** The method of claim 5, wherein angles of the at least two contributor phasors are parametrized such that their difference is a non-constant function of the tilt.

**7.** The method of one of the previous claims, wherein the target of the optical measurement system has a range of tilt positions.

**8.** The method of one of the previous claims, wherein

the step of determining an error during a first measurement comprises measuring over N points a first optical characteristic for the target at a first position or first angular orientation,
and wherein the method comprises the steps of:

determining, based on the first optical characteristic, a first set of P parameters indicative of observed physical effects including tilt-dependent non-linearities, to provide the error model function,
using said error model function as basis of further correction,

wherein the step of updating a subset of the parameters comprising measuring over M points a further optical characteristic for the target, where M < N,

determining, based on the measurement over M points and the physical model, a correction to the measurement over M points to reduce tilt-dependent non-linearities, and
updating a subset of the first set of P parameters on the basis of the measurement over M points to provide the updated error model function.

**9.** The method of claim 3, 4 or 8, wherein the absolute of at least one of the phasors is an oscillating tilt dependency with varying amplitude.

**10.** The method of claim 9, wherein the non-constant function of the tilt is an oscillating tilt-dependency with Gaussian envelope.

**11.** The method of one of the previous claims, wherein the optical measurement system is an interferometer system.

**12.** Optical measurement system involving radiation interference, the system comprising:
first measurement means for determining an error of the optical measurement system, wherein a target of the optical measurement system is tilted in one or more degrees of freedom and for defining parameters of an error model function based on the first measurement;

second measurement means for determining an error of the optical measurement system during at least one second measurement, wherein the at least one second measurement comprises fewer data points than the first measurement; and
a control system adapted for updating a subset of the parameters of the error model function to define an updated error model function based on an output of the second measurement means.

**13.** The system of claim 12, adapted to implement the method according to one of claims 1 to 11.

**14.** An exposure apparatus, comprising at least one optical measurement system according to claim 12.

**15.** A projection system for an optical lithography system, the projection system comprising at least one optical measurement system according to claim 12 or configured to carry out the method of any of claims 1 to 11.

# Fig. 1

# Fig. 2

SO2

IL2

DS

D

MA2

MT2

# Fig. 3

VP

SO3

ES

TM

GS

RE

MS

6

BG

OS

5

# Fig. 4

# Fig. 5

Fig. 6

Fig. 7

Fig. 8

## Fig. 9

EP 4 657 009 A1

Europäisches
Patentamt
European
Patent Office
Office européen
des brevets

# EUROPEAN SEARCH REPORT

**Application Number**

EP 24 17 8736

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/187464 A1 (WOMACK GARY [US] ET AL) 24 August 2006 (2006-08-24) | 1-3,7,8, 11-15 | INV. G01B9/02055 |
| Y | * the whole document * | 4-6,9,10 | G01B21/04 G03F7/00 |
| Y | US 2007/058174 A1 (HILL HENRY A [US]) 15 March 2007 (2007-03-15) * the whole document * | 4-6 | |
| Y | US 2007/008547 A1 (HILL HENRY A [US] ET AL) 11 January 2007 (2007-01-11) * the whole document * | 9,10 | |
| A | JP 2017 032442 A (MITUTOYO CORP) 9 February 2017 (2017-02-09) * the whole document * | 1-15 | |

**TECHNICAL FIELDS SEARCHED (IPC)**

G01B
G03F

The present search report has been drawn up for all claims

| Place of search | Date of completion of the search | Examiner |
|---|---|---|
| Munich | 9 December 2024 | Ardelt, Per-Lennart |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 17 8736

09-12-2024

| Patent document cited in search report | | | Publication date | Patent family member(s) | | Publication date |
|---|---|---|---|---|---|---|
| US 2006187464 | A1 | | 24-08-2006 | JP | 2009528541 A | 06-08-2009 |
| | | | | US | 2006187464 A1 | 24-08-2006 |
| | | | | WO | 2007103082 A2 | 13-09-2007 |
| US 2007058174 | A1 | | 15-03-2007 | TW | 200706831 A | 16-02-2007 |
| | | | | US | 2007058174 A1 | 15-03-2007 |
| | | | | WO | 2007019548 A2 | 15-02-2007 |
| US 2007008547 | A1 | | 11-01-2007 | NONE | | |
| JP 2017032442 | A | | 09-02-2017 | JP | 6539145 B2 | 03-07-2019 |
| | | | | JP | 2017032442 A | 09-02-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11287242 B2

- US 6950192 B2